# EUROPÄISCHE PATENTSCHRIFT

(11) **EP 2 504 917 B1**
(45) Veröffentlichungstag und Bekanntmachung des Hinweises auf die Patenterteilung: **05.09.2018**
(21) Anmeldenummer: 10760732.7
(22) Anmeldetag: 07.10.2010
(51) Int. Cl.: H02P 7/29, G01R 19/00

(54) **VORRICHTUNG UND VERFAHREN ZUM MESSEN EINES MOTORSTROMS EINES GLEICHSTROMMOTORS**
APPARATUS AND METHOD FOR MEASUREMENT OF A MOTOR CURRENT OF A DIRECT-CURRENT MOTOR
DISPOSITIF ET PROCÉDÉ POUR MESURER UN COURANT DE MOTEUR D'UN MOTEUR À COURANT CONTINU

(30) Priorität: 24.11.2009 DE 102009047042
(43) Veröffentlichungstag der Anmeldung: 03.10.2012
(73) Patentinhaber: Robert Bosch GmbH, 70442 Stuttgart (DE)
(72) Erfinder: VAN GOETHEM, Jan, F-67760 Gambsheim (FR); ROOS, Gerald, 77855 Sasbachried (DE)
(86) Internationale Anmeldenummer: PCT/EP2010/064958
(87) Internationale Veröffentlichungsnummer: WO 2011/064030

(56) Entgegenhaltungen:
- DE-A1- 2 716 272
- DE-A1- 3 813 066
- DE-A1- 19 640 190
- JP-A- 2003 189 571
- US-A- 4 511 829
- US-A- 4 656 402
- US-A- 4 661 766
- US-A1- 2002 149 349

## Beschreibung

### Technisches Gebiet

Die Erfindung betrifft eine Vorrichtung und ein Verfahren zum Messen eines Motorstroms in einem bürstenkommutierten Gleichstrommotor, insbesondere durch eine Strommesseinheit mit einem Messwiderstand.

### Stand der Technik

Bürstenkommutierte Gleichstrommotoren werden häufig über einen Spannungssteller angesteuert, wobei die dem Gleichstrommotor zugeführte elektrische Leistung durch ein Tastverhältnis eingestellt wird. Der Spannungssteller ist im Wesentlichen ein Schalter, der den Gleichstrommotor mit der Versorgungsspannung verbindet oder von dieser trennt. Das Tastverhältnis gibt an, wie der Spannungssteller zyklisch geöffnet bzw. geschlossen wird, um dem Gleichstrommotor eine bestimmte elektrische Leistung bereitzustellen.

Um einen Motorstrom durch den Gleitstrommotor zu messen, ist üblicherweise eine Strommesseinrichtung zwischen der Spannungsversorgung und dem Spannungssteller vorgesehen. Die Strommesseinrichtung ist üblicherweise durch einen Messwiderstand ausgebildet. Insbesondere bei hohen Tastverhältnissen, bei denen das Verhältnis der Zeitdauer, während der Spannungssteller geschlossen (durchgeschaltet) ist, zur gesamten Periodendauer der Pulsweitenmodulation hoch ist, fließen relativ hohe Ströme durch den Messwiderstand, so dass dort trotz geringem Widerstand eine vergleichsweise hohe Verlustleistung entstehen kann.

Je nach Schaltzustand legt der Spannungssteller an den Gleichstrommotor die Versorgungsspannung an oder trennt diese davon. Um eine durch die Drehung des Gleichstrommotors erzeugte Generatorspannung bei einem geöffneten Spannungssteller abzubauen, ist üblicherweise ein Freilaufkreis vorgesehen, in dem ein Ableitelement in Form einer Freilaufdiode angeordnet ist. Dieses Ableitelement dienen zum Schutz vor einer Überspannung an den Bauelementen des Spannungsstellers beim Abschalten der induktiven Gleichspannungslast des Gleichstrommotors.

Die Druckschrift DE 196 40 190 A1 offenbart eine Schaltung zur Ermittlung des Laststroms einer getaktet angesteuerten, zumindest einen induktiven Anteil aufweisenden Last, der ein Freilaufkreis zugeordnet ist. Im Freilaufkreis ist eine Spannungsmessschaltung angeordnet, deren Spannungsabfall zur Stromermittlung herangezogen wird. Dazu wird der Freilaufstrom als Maß für die Bestimmung des Laststroms herangezogen.

Die Druckschrift US 4 656 402 A beschreibt eine elektronische Motorsteuerung, wobei ein pulsförmiger Laststrom durch einen elektrischen Motor detektiert wird. Der Laststrom wird durch eine Pulsweitenmodulation gesteuert und durch einen Stromdetektor gemessen. Ein Mittelwert des Laststroms wird anhand der Stromwerte des Laststroms am Anfang und am Ende der Einschaltzeit der Pulsweitenmodulation bestimmt.

Die Druckschrift JP 2003 189571 offenbart einen Elektromotor mit mehreren unabhängig voneinander ansteuerbaren Bürstenpaaren.

Es ist Aufgabe der vorliegenden Erfindung, eine einfache Strommessung bei einem Gleichstrommotor mit mehreren voneinander unabhängig ansteuerbaren Bürstenpaaren vorzunehmen.

### Offenbarung der Erfindung

Diese Aufgabe wird durch die Vorrichtung nach Anspruch 1 sowie durch das Verfahren nach Anspruch 7 gelöst.

Weitere vorteilhafte Ausgestaltungen sind in den abhängigen Ansprüchen angegeben.

Eine Idee der vorliegenden Erfindung besteht darin, die Stommesseinrichtung im Freilaufkreis des Spannungsstellers vorzusehen, sodass während der Zeiträume, in denen sich der Spannungssteller im ausgeschalteten d.h. geöffneten Zustand befindet, die von dem Gleichstrommotor beim Abschalten der induktiven Gleichspannungslast des Gleichstrommotors generierte Überspannung ein Weiterfließen des Motorstroms durch die Freilaufdiode über die Strommesseinrichtung zur Folge hat. Somit wird insbesondere bei hoher Leistungsabgabe, d.h. bei einem hohen Tastverhältnis von z.B. größer 0,5, der Freilaufkreis zeitlich weniger belastet als die Versorgungsleitung, in der sich bei herkömmlichen Motorsystemen die Strommesseinrichtung befindet. Somit sind der Effektivwert des Freilaufstroms und die dadurch resultierenden Verluste in der Strommesseinrichtung gegenüber den herkömmlichen Motorsystemen deutlich reduziert.

Gemäß einer Ausführungsform kann der Freilaufkreis eine Freilaufdiode umfassen, die bezüglich der Versorgungsspannung in Sperrrichtung gepolt ist, wobei die Freilaufdiode in Reihe mit dem Leistungshalbleiterschalter verschaltet ist.
Die Auswerteeinheit kann ausgebildet sein, um den Mittelwert des Freilaufkreisstroms als Mittelwert aus zwei Freilaufströmen, die zu unterschiedlichen Zeitpunkten während der Zeitdauer, insbesondere zu Beginn der Zeitdauer und zu Ende der Zeitdauer, erfasst werden, zu bestimmen.

Gemäß einem weiteren Aspekt ist ein Motorsystem mit einem Gleichstrommotor und der obigen Vorrichtung zur Ermittlung des Motorstroms vorgesehen. Eine Steuereinheit ist vorgesehen, um den Spannungssteller gemäß einer Vorgabegröße so anzusteuern, dass dem Gleichstrommotor eine durch die Vorgabegröße angegebene elektrische Leistung bereitgestellt wird.
Weiterhin kann die Steuereinheit ausgebildet sein, um den Spannungssteller gemäß einer Pulsweitenmodulation mit einem von der Vorgabegröße abhängigen Tastverhältnis anzusteuern, und um die Auswerteeinheit zu veranlassen, die Mittelung des Freilaufkreisstroms durchzuführen, während der Spannungssteller den Gleichstrommotor von der Versorgungsspannung getrennt hat.
Insbesondere kann die Auswerteeinheit in der Steuereinheit vorgesehen sein.

### Kurzbeschreibung der Zeichnungen

Ausführungsformen der Erfindung werden nachfolgend anhand der beigefügten Zeichnungen näher erläutert. Es zeigen:
- Figur 1: eine schematische Darstellung eines Motorsystems mit einer Vorrichtung zur Ermittlung des Motorstroms;
- Figur 2: Signal-Zeit-Diagramme zur Veranschaulichung des Verfahrens zum Bestimmen des Motorstroms mit der Vorrichtung gemäß Figur 1; und
- Figur 3: eine schematische Darstellung eines Motorsystems mit einer Vorrichtung zur Ermittlung des Motorstroms bei einem Gleichstrommotor mit mehreren getrennt voneinander bestromten Bürstenpaaren.

### Beschreibung von Ausführungsformen

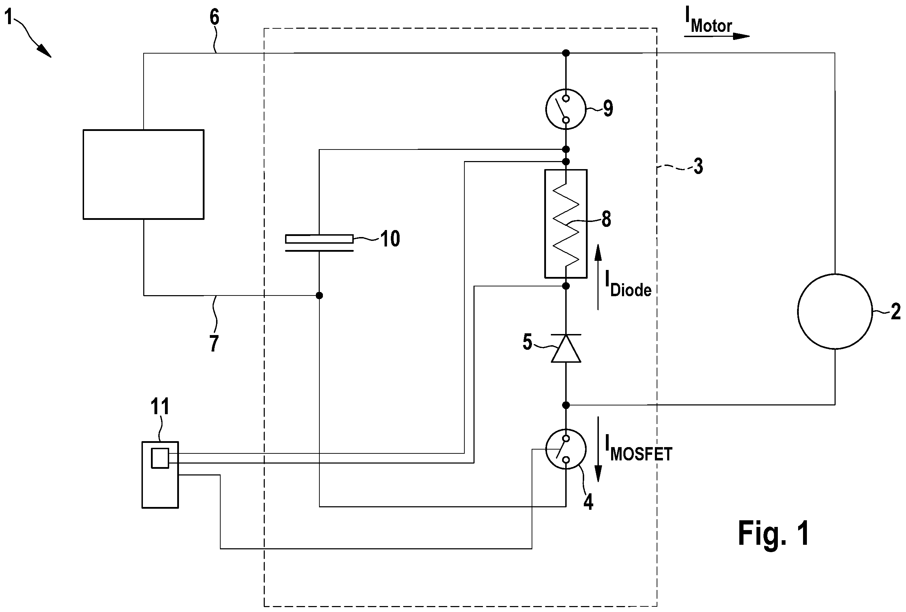

In Figur 1 ist eine schematische Darstellung eines Motorsystems 1 gezeigt. Das Motorsystem 1 umfasst einen bürstenkommutieren Gleichstrommotor 2 und einen Spannungssteller 3, der einen Leistungshalbleiterschalter 4 aufweist. Der Spannungssteller 3 dient dazu, dem Gleichstrommotor 2 eine variable, einstellbare Leistung bereit zu stellen.

Der Spannungssteller 3 umfasst in der Regel einen Leistungshalbleiterschalter, z.B. in Form eines MOSFETs, Thyristors, IGBT und dergleichen, je nach Anforderungen an das Motorsystem 1. Es ist eine Steuereinheit 11 vorgesehen, die den Leistungshalbleiterschalter 4 gemäß einer Pulsweitenmodulation ansteuert, um diesen zu öffnen, d.h. elektrisch nicht-leitend zu schalten, oder zu schließen, d.h. elektrisch durchzuschalten. Dazu erhält die Steuereinheit 11 eine Angabe über die bereitzustellende Motorleistung und ermittelt in bekannter Weise ein entsprechendes Tastverhältnis, mit dem der Leistungshalbleiterschalter 4 angesteuert werden soll. Bei einer Pulsweitenmodulation wird in einen schnellen Wechsel eine Versorgungsspannung Uᵥₑᵣₛ an den Gleichstrommotor 2 angelegt und dieser davon wieder getrennt. Dieser Vorgang findet periodisch bei in der Regel gleichen Zykluszeitdauern statt, wobei das Verhältnis der Zeitdauer, während der die Versorgungspannung an dem Gleichstrommotor 2 anliegt, zur gesamten Periodendauer der Pulsweitenmodulation dem Tastverhältnis entspricht.

Der Spannungssteller 3 umfasst weiterhin eine Freilaufdiode 5, um eine Motorspannung mit einer der Versorgungsspannung entgegengesetzten Polarität durch Leiten der Freilaufdiode 5 abzubauen. Die Freilaufdiode 5 ist so gepolt, dass sie eine Überspannung beim Abschalten der induktiven Gleichspannungslast des Gleichstrommotors 2 bei Nichtanliegen der Versorgungsspannung Uᵥₑᵣₛ ableitet, indem sie den Gleichstrommotor 2 quasi kurzschließt.

Im Detail ist ein erster Anschluss des Gleichstrommotors 2 mit einer ersten Versorgungsspannungsleitung 6 und ein zweiter Anschluss des Gleichstrommotors 2 mit einem ersten Anschluss des Leistungshalbleiterschalters 4 verbunden. Ein zweiter Anschluss des Leistungshalbleiterschalters 4 ist mit einer zweiten Versorgungsspannungsleitung 7 verbunden. An den Versorgungsspannungsleitungen 6, 7 liegt die Versorgungsspannung Uᵥₑᵣₛ an. Ein Kathodenanschluss der Freilaufdiode 5 ist ebenfalls mit dem ersten Anschluss des Leistungshalbleiterschalters 4 verbunden.

Es ist eine Strommesseinrichtung in Form eines Messwiderstandes 8 im Freilaufkreis vorgesehen, wobei der Messwiderstand 8 in Reihe zu der Freilaufdiode 5 angeordnet ist. Dazu ist im vorliegenden Ausführungsbeispiel der Anodenanschluss der Freilaufdiode 5 mit einem ersten Anschluss des Messwiderstandes 8 verbunden.

Ein zweiter Anschluss des Messwiderstandes 8 kann über ein Verpolschutzelement 9 mit der ersten Versorgungsspannungsleitung 6 verbunden sein. Das Verpolschutzelement 9 kann einen Verpol-MOSFET aufweisen und gewährleistet, dass im Falle einer Verpolung der Versorgungsspannung kein Kurzschluss durch die Freilaufdiode 5 über die parasitäre Diode des Leistungshalbleiterschalters 4 entsteht. Das heißt im Falle einer Verpolung wird der Verpol-MOSFET durch die Steuereinheit 11 geöffnet. Der zweite Anschluss des Messwiderstandes 8 ist weiterhin mit einem ersten Anschluss einer Kapazität 10 verbunden. Der zweite Anschluss der Kapazität 10 ist mit der zweiten Versorgungsspannungsleitung 7 verbunden.

Eine Idee besteht darin, den Motorstrom durch den Gleichstrommotor 2 aus einer Angabe über den Strom durch die Freilaufdiode im Freilaufkreis abzuleiten, der fließt, wenn der Leistungshalbleiterschalter 4 des Spannungsstellers 3 geöffnet ist. Die Strommessung im Freilaufkreis wird durchgeführt, indem die Messspannung an dem Messwiderstand 8 abgegriffen wird. Die Messspannung U_{Mess} kann mit Hilfe eines Analog-Digital-Wandlers in einer Auswerteeinheit 12 in (oder außerhalb) der Steuereinheit 11 erfasst und digitalisiert werden. Die Messspannung stellt ein Maß für den aktuell durch den Messwiderstand 8 fließenden Strom dar. Eine digitale Angabe für die Messspannung wird daher als Maß für den durch den Freilaufkreis fließenden Strom der Steuereinheit 11 als Stromangabe bereitgestellt.

Die im Steuergerät 11 bereitgestellte Stromangabe wird während der Zeit, während der der Leistungshalbleiterschalter 4 geöffnet ist, zeitlich gemittelt, wobei die gemittelte Stromangabe eine Angabe über den fließenden Motorstrom darstellt.

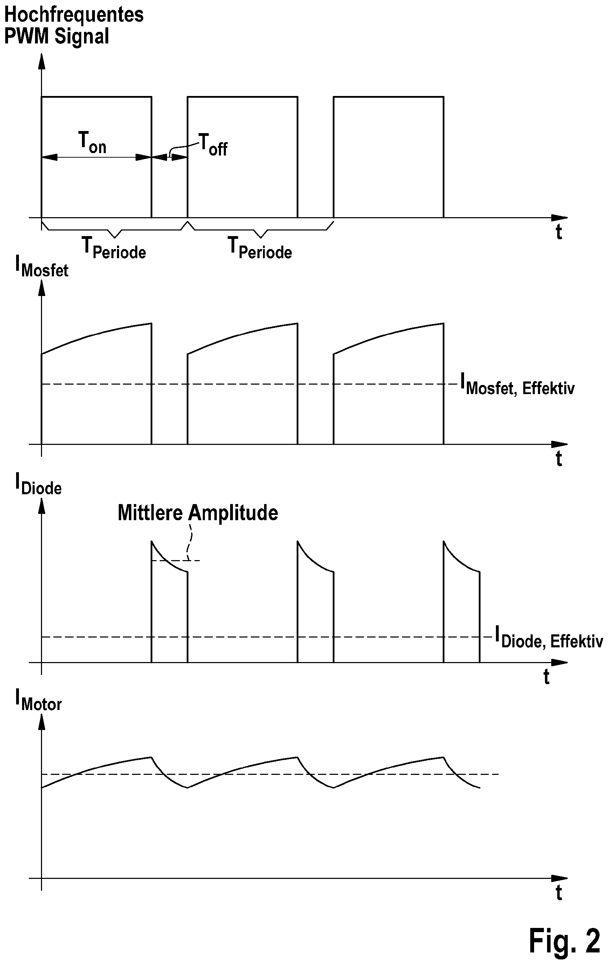

In Figur 2 sind die zeitlichen Verläufe des an den Leistungshalbleiterschalter 4 angelegten Ansteuersignals, das von der Steuereinheit 11 generiert wird, sowie die Verläufe des Stroms durch die Leistungshalbleiterschalter I_{MOSFET} und des Diodenstroms I_{Diode} durch die Freilaufdiode dargestellt. Im vorliegenden Fall ist eine Ansteuerung bei einem Tastverhältnis von 0,8 dargestellt, d.h. während einer Periodendauer T_{periode} der Pulsweitenmodulation ist der Leistungshalbleiterschalter 4 zu 80% der Periodendauer T_{periode} durchgeschaltet und zu 20% der Periodendauer T_{periode} geöffnet.

Zur Ermittlung des Motorstroms wird der gemittelte, während des geöffneten Zustandes des Leistungshalbleiterschalters 4 durch den Freilaufkreis fließende Strom näherungsweise als der Motorstrom I_{Motor} betrachtet. Das heißt, wird während des Zeitfensters innerhalb der Periodendauer der Pulsweitenmodulation, während der der Leistungshalbleiterschalter 4 ausgeschaltet, d.h. geöffnet ist, die mittlere Stromangabe des Diodenstroms I_{Diode} durch die Freilaufdiode 5 ermittelt, so entspricht diese dem mittleren Motorstrom durch den Gleichstrommotor 2. Gleichzeitig ist ein effektiver Diodenstrom I_{Diode_eff} gering, da aufgrund des relativ hohen Tastverhältnisses die Zeitfenster, während denen der Freilaufstrom fließt, kürzer sind als die Zeitfenster, während denen der Strom durch den Leistungshalbleiter 4 fließt, z.B. weniger als 50% der gesamten Periodendauer der Pulsweitenmodulation beträgt.

Die mittlere Amplitude des durch den Freilaufkreis fließenden Stroms kann beispielsweise in der Auswerteeinheit 12 in der Steuereinheit 11 ermittelt werden, indem zu einem Zeitpunkt nach dem Ausschalten des Leistungshalbleiterschalters 4, wenn sich - nach einem etwaigen Einschwingvorgang - der Diodenstrom durch die Freilaufdiode eingestellt hat, eine erste Stromangabe und zu einem Zeitpunkt vor einem Einschalten bzw. zu einem Zeitpunkt des Einschaltens des Leistungshalbleiterschalters 4 eine zweite Stromangabe gemessen werden. Unter der Annahme eines annähernd linearen Verlaufs des durch den Freilaufkreis fließenden Stroms werden die beiden Stromwerte gemittelt, um den gemittelten Diodenstrom zu erhalten, der ein Maß für den Strom durch den Gleichstrommotor 2 darstellt.

Alternativ sind auch andere Verfahren zum Bestimmen des gemittelten Diodenstroms I_{Diode} durch die Freilaufdiode 5 anwendbar. Aus dem Verlauf des Motorstroms I_{Motor}, der rechts in Figur 2 dargestellt ist, erkennt man im Vergleich, dass die Höhe des gemittelten Diodenstroms I_{Diode} der Höhe des gemittelten Motorstroms I_{Motor} durch den Leistungshalbleiterschalter 4 entspricht.

Die Strommessung durch einen Messwiderstand 8 im Freilaufkreis hat den Vorteil, dass insbesondere bei Motorbetriebszuständen, bei denen hohe Motorströme fließen, wie es beispielsweise bei großen Tastverhältnissen der Fall ist, die zeitliche Dauer des Stromflusses durch den Messwiderstand 8 kleiner ist als wenn der Messwiderstand in einer der Versorgungsspannungsleitungen 7 angeordnet wäre. Dadurch kann die Verlustleistung in dem Messwiderstand 8 verringert werden.

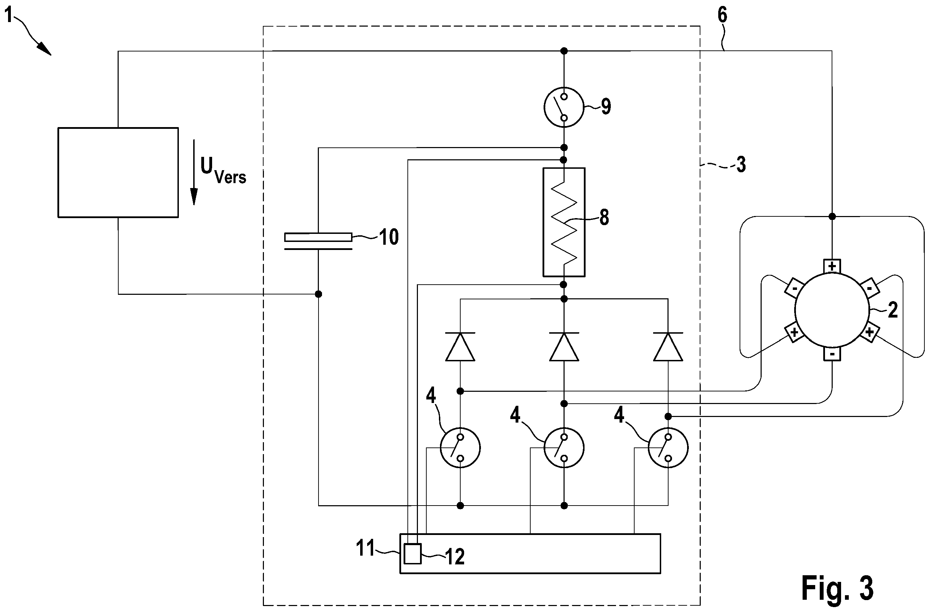

In Figur 3 ist eine weitere Ausführungsform einer Vorrichtung zum Bestimmen eines Motorstroms durch einen Gleichstrommotor 2 dargestellt. Bei dem Motorsystem der Figur 3 ist ein Gleichstrommotor 2 vorgesehen, der drei Bürstenpaare vorsieht. Bei dem Gleichstrommotor 2 handelt es sich um einen Gleichstrommotor 2, bei dem bei jeder Rotorlage eines Rotors des Gleichstrommotors 2 jedes der Bürstenpaare eine Rotorwicklung kontaktiert, die nicht mit den übrigen Rotorwicklungen in elektrischer Verbindung steht.

Erste Bürstenelektroden der Bürstenpaare sind miteinander und mit der ersten Versorgungsspannungsleitung 6 verbunden. Jeweils zweite Bürstenelektroden der Bürstenpaare sind über einen zugeordneten Leistungshalbleiterschalter 4 des Spannungsstellers 3 mit der zweiten Versorgungsleitung 7 verbunden. Weiterhin ist jede der zweiten Bürstenelektroden über eine zugeordnete Freilaufdiode 5 mit einem gemeinsamen Messwiderstand 8 verbunden. Verpolschutzelement 9 und Kapazität 10 sind wie bei der Ausführungsform der Fig. 1 angeordnet.

Die Leistungshalbleiterschalter 4 werden wie oben beschrieben gemäß einer Pulsweitenmodulation mit einem Tastverhältnis durch die Steuereinheit 11 angesteuert, wobei vorzugsweise die Ansteuerung so erfolgt, dass die Periodendauern der Pulsweitenmodulationen phasenversetzt sind. Auf diese Weise kann gewährleistet werden, dass bei hohen Tastverhältnissen keine Überschneidungen der Zustände auftreten, bei denen gleichzeitig mehr als einer der Leistungshalbleiterschalter 4 geöffnet ist. Insgesamt kann bei obigem Verfahren zur Messung des Motorstroms die Verlustleistung in dem Messwiderstand reduziert werden. Aufgrund des versetzten Taktens kann Reduzierung der Zwischenkreiskapazität bei Konstruktion erreicht werden

Die oben beschriebene Bestimmung des Motorstroms ist in gleicher Weise anwendbar, solange nur einer der Leistungshalbleiterschalter 4 gleichzeitig geöffnet ist. Sind der Phasenversatz der Ansteuerung und/oder das Tastverhältnis so gewählt, dass gleichzeitig mehr als einer der Leistungshalbleiterschalter 4 geöffnet ist, so sollte die Mittelung des Freilaufstroms während der Zeitdauer durchgeführt werden, während der sich die Anzahl der geöffneten Leistungshalbleiterschalter 4 nicht ändert. Zudem muss der gemittelte Freilaufstrom durch die Anzahl der gleichzeitig geöffneten Leistungshalbleiterschalter 4 dividiert werden, damit von dem gemessenen gemittelten Freilaufstrom der Motorstrom abgeleitet werden kann.

## Patentansprüche

1. Vorrichtung zur Ermittlung des Motorstroms (I_{Motor}) durch einen Gleichstrommotor (2) in einem Motorsystem (1) **gekennzeichnet durch**:
- mehrere Spannungssteller (3), die jeweils einen Leistungshalbleiterschalter (4) umfassen, um jeweils ein Bürstenpaar des Gleichstrommotors (2) zyklisch mit einer Versorgungsspannung (U_{Vers}) zu verbinden oder von dieser zu trennen,
- Freilaufkreise, die jeweils in Reihe mit einem zugeordneten der Leistungshalbleiterschalter (4) geschaltet sind, um vor einer Überspannung beim Abschalten einer induktiven Gleichspannungslast des Gleichstrommotors (2) zu schützen;
- eine in den Freilaufkreisen vorgesehene Strommesseinrichtung (8), um einen Freilaufkreisstrom zu messen; und
- eine Auswerteeinheit (12), um während einer Zeitdauer, während der ein oder mehrere der Leistungshalbleiterschalter (4) gleichzeitig geöffnet sind und so der Gleichstrommotor (2) von der Versorgungsspannung (U_{Vers}) getrennt ist, einen Mittelwert des Freilaufkreisstroms zu bestimmen und als eine Angabe für den Motorstrom (I_{Motor}) den Mittelwert des Freilaufkreisstroms bereitzustellen, wobei bei mehreren gleichzeitig geöffneten Leistungshalbleiterschaltern (4) der Mittelwert des Freilaufstroms durch die Anzahl der mehreren gleichzeitig geöffneten Leistungshalbleiterschalter (4) dividiert wird, um den Motorstrom (I_{Motor}) abzuleiten, wobei die Strommesseinrichtung (8) einen gemeinsamen Messwiderstand aufweist, der in allen Freilaufkreisen vorgesehen ist.

2. Vorrichtung nach Anspruch 1, wobei die Freilaufkreis jeweils eine Freilaufdiode (5) umfasst, die bezüglich der Versorgungsspannung in Sperrrichtung gepolt ist, wobei die Freilaufdiode (5) in Reihe mit dem Leistungshalbleiterschalter (4) verschaltet ist.

3. Vorrichtung nach einem der Ansprüche 1 bis 2, wobei die Auswerteeinheit (12) ausgebildet ist, um den Mittelwert des Freilaufkreisstroms als Mittelwert aus zwei Freilaufströmen, die zu unterschiedlichen Zeitpunkten während der Zeitdauer, insbesondere zu Beginn der Zeitdauer und zu Ende der Zeitdauer, erfasst werden, zu bestimmen.

4. Motorsystem (1) mit einem Gleichstrommotor (2) und einer Vorrichtung nach einem der vorangehenden Ansprüche,
wobei eine Steuereinheit (11) vorgesehen ist, um den Spannungssteller (3) gemäß einer Vorgabegröße so anzusteuern, dass dem Gleichstrommotor (2) eine durch die Vorgabegröße angegebene elektrische Leistung bereitgestellt wird.

5. Motorsystem nach Anspruch 4, wobei die Steuereinheit (11) ausgebildet ist, um den Spannungssteller (3) gemäß einer Pulsweitenmodulation mit einem von der Vorgabegröße abhängigen Tastverhältnis anzusteuern, und um die Auswerteeinheit (12) zu veranlassen, die Mittelung des Freilaufkreisstroms durchzuführen, während der Spannungssteller (3) den Gleichstrommotor (2) von der Versorgungsspannung (U_{Vers}) getrennt hat.

6. Motorsystem (1) nach Anspruch 4 oder 5, wobei die Auswerteeinheit (12) in der Steuereinheit (11) vorgesehen ist.

7. Verfahren zur Ermittlung des Motorstroms (I_{Motor}) durch einen Gleichstrommotor (2) in einem Motorsystem (1), **gekennzeichnet durch** folgende Schritte:
- Betreiben des Gleichstrommotors mittels mehrerer Spannungssteller (3), die jeweils einen Leistungshalbleiterschalter (4) umfassen, um jeweils ein Bürstenpaar des Gleichstrommotors (2) zyklisch mit einer Versorgungsspannung (U_{Vers}) zu verbinden oder von dieser zu trennen,
- Messen von Freilaufkreisströmen in Freilaufkreisen, die jeweils in Reihe mit einem zugeordneten der Leistungshalbleiterschalter (4) geschaltet sind und die vorgesehen sind, um vor einer Überspannung beim Abschalten einer induktiven Gleichspannungslast des Gleichstrommotors (2) zu schützen, wobei die Freilaufkreise mit einer für alle Freilaufkreise gemeinsamen Strommesseinrichtung (8) gemessen werden, wobei die Strommesseinrichtung (8) einen gemeinsamen Messwiderstand aufweist, der in allen Freilaufkreisen vorgesehen ist;
- Messen des Freilaufkreisstroms;
- Bestimmen eines Mittelwert der Freilaufkreisströme während einer Zeitdauer, während der ein oder mehrere der Leistungshalbleiterschalter (4) gleichzeitig geöffnet sind und so der Gleichstrommotor (2) von der Versorgungsspannung (U_{Vers}) getrennt ist, wobei bei mehreren gleichzeitig geöffneten Leistungshalbleiterschaltern (4) der Mittelwert des Freilaufstroms durch die Anzahl der mehreren gleichzeitig geöffneten Leistungshalbleiterschalter (4) dividiert wird, um den Motorstrom (I_{Motor}) abzuleiten, und
- Bereitstellen des Mittelwerts der Freilaufkreisströme als eine Angabe für den Motorstrom (I_{Motor}).

## Claims

1. Apparatus for identifying the motor current (I_{Motor}) through a DC motor (2) in a motor system (1), **characterized by**:
- a plurality of voltage controllers (3), which each comprise a power semiconductor switch (4) in order in each case to cyclically connect a brush pair of the DC motor (2) to a supply voltage (U_{Vers}) or to cyclically isolate said brush pair therefrom,
- freewheeling circuits, which are each connected in series with an associated one of the power semiconductor switches (4) in order to protect against an overvoltage in the case of disconnection of an inductive DC voltage load of the DC motor (2);
- a current measurement device (8) provided in the freewheeling circuits in order to measure a freewheeling circuit current; and
- an evaluation unit (12) in order to determine an average value of the freewheeling circuit current during a period in which one or more of the power semiconductor switches (4) are open at the same time and the DC motor (2) is thus isolated from the supply voltage (U_{Vers}) and in order to provide the average value of the freewheeling circuit current as an indication of the motor current (I_{Motor}), wherein, in the case of a plurality of power semiconductor switches (4) being open at the same time, the average value of the freewheeling current is divided by the number of the plurality of power semiconductor switches (4) that are open at the same time in order to derive the motor current (I_{Motor}), wherein the current measurement device (8) has a common measurement resistor that is provided in all the freewheeling circuits.

2. Apparatus according to Claim 1, wherein the freewheeling circuit comprises in each case a freewheeling diode (5), which is polarized in the blocking direction with respect to the supply voltage, wherein the freewheeling diode (5) is interconnected in series with the power semiconductor switch (4).

3. Apparatus according to one of Claims 1 to 2, wherein the evaluation unit (12) is configured to determine the average value of the freewheeling circuit current as the average value of two freewheeling currents, which are detected at different times during the period, in particular at the beginning of the period and at the end of the period.

4. Motor system (1) having a DC motor (2) and an apparatus according to one of the preceding claims, wherein a control unit (11) is provided in order to actuate the voltage controller (3) according to a preset variable so that an electrical power specified by the preset variable is supplied to the DC motor (2).

5. Motor system according to Claim 4, wherein the control unit (11) is configured to actuate the voltage controller (3) according to a pulse-width modulation having a duty cycle dependent on the preset variable and to cause the evaluation unit (12) to perform the averaging of the freewheeling circuit current while the voltage controller (3) has isolated the DC motor (2) from the supply voltage (U_{Vers}).

6. Motor system (1) according to Claim 4 or 5, wherein the evaluation unit (12) is provided in the control unit (11) .

7. Method for identifying the motor current (I_{Motor}) through a DC motor (2) in a motor system (1), **characterized by** the following steps:
- operating the DC motor by means of a plurality of voltage controllers (3), which each comprise a power semiconductor switch (4) in order in each case to cyclically connect a brush pair of the DC motor (2) to a supply voltage (U_{Vers}) or to cyclically isolate said brush pair therefrom,
- measuring freewheeling circuit currents in freewheeling circuits, which are each connected in series with an associated one of the power semiconductor switches (4) and which are provided to protect against an overvoltage in the case of disconnection of an inductive DC voltage load of the DC motor (2), wherein the freewheeling circuits are measured using a current measurement device (8) common to all the freewheeling circuits, wherein the current measurement device (8) has a common measurement resistor that is provided in all the freewheeling circuits;
- measuring the freewheeling circuit current;
- determining an average value of the freewheeling circuit currents during a period in which one or more of the power semiconductor switches (4) are open at the same time and the DC motor (2) is thus isolated from the supply voltage (U_{Vers}), wherein, in the case of a plurality of power semiconductor switches (4) being open at the same time, the average value of the freewheeling current is divided by the number of the plurality of power semiconductor switches (4) that are open at the same time in order to derive the motor current (I_{Motor}), and
- providing the average value of the freewheeling circuit currents as an indication of the motor current (I_{Motor}).

## Revendications

1. Dispositif de détermination du courant de moteur (I_{Motor}) à travers un moteur à courant continu (2) dans un système de moteur (1), **caractérisé par** :
- plusieurs hacheurs de tension (3) qui comprennent respectivement un commutateur à semiconducteur (4) pour, cycliquement, relier à chaque fois une paire de balais du moteur à courant continu (2) à une tension d'alimentation (U_{Vers}) où l'en déconnecter,
- des circuits de roue libre qui sont respectivement branchés en série avec un associé parmi les commutateurs à semiconducteur (4) afin de le protéger contre une surtension lors de la mise hors circuit d'une charge à tension continue inductive du moteur à courant continu (2) ;
- un appareil de mesure du courant (8) présent dans le circuit de roue libre afin de mesurer un courant du circuit de roue libre ; et
- une unité d'interprétation (12) pour, pendant une période durant laquelle ledit ou plusieurs des commutateurs à semiconducteur (4) sont ouverts simultanément et le moteur à courant continu (2) est ainsi déconnecté de la tension d'alimentation (Uvers), déterminer une valeur moyenne du courant du circuit de roue libre et fournir la valeur moyenne du courant du circuit de roue libre comme une indication du courant de moteur (I_{Motor}), la valeur moyenne du courant de roue libre étant divisée par le nombre des plusieurs commutateurs à semiconducteur (4) qui sont ouverts simultanément afin de dériver le courant de moteur (I_{Motor}) lorsque plusieurs des commutateurs à semiconducteur (4) sont ouverts simultanément,
l'appareil de mesure du courant (8) possédant une résistance de mesure commune qui est présente dans tous les circuits de roue libre.

2. Dispositif selon la revendication 1, le circuit de roue libre comportant respectivement une diode de roue libre (5) qui est polarisée dans le sens du blocage par rapport à la tension d'alimentation, la diode de roue libre (5) étant branchée en série avec le commutateur à semiconducteur (4).

3. Dispositif selon l'une des revendications 1 à 2, l'unité d'interprétation (12) étant configurée pour déterminer la valeur moyenne du courant de circuit de roue libre en tant que valeur moyenne de deux courants de roue libre qui sont détectés à des instants différents pendant la période, notamment au début de la période et à la fin de la période.

4. Système de moteur (1) comprenant un moteur à courant continu (2) et un dispositif selon l'une des revendications précédentes,
une unité de commande (11) étant présente pour piloter les hacheurs de tension (3) conformément à une grandeur prédéfinie de telle sorte qu'une puissance électrique indiquée par la grandeur prédéfinie est fournie au moteur à courant continu (2).

5. Système de moteur selon la revendication 4, l'unité de commande (11) étant configurée pour piloter le hacheur de tension (3) conformément à une modulation d'impulsions en durée avec un rapport cyclique dépendant de la grandeur prédéfinie et pour amener l'unité d'interprétation (12) à effectuer le calcul de la moyenne du courant de circuit de roue libre pendant que le hacheur de tension (3) a déconnecté le moteur à courant continu (2) de la tension d'alimentation (U_{Vers}).

6. Système de moteur (1) selon la revendication 4 ou 5, l'unité d'interprétation (12) se trouvant dans l'unité de commande (11).

7. Procédé de détermination du courant de moteur (I_{Motor}) à travers un moteur à courant continu (2) dans un système de moteur (1), **caractérisé par** les étapes suivantes :
- mise en fonctionnement du moteur à courant continu au moyen de plusieurs hacheurs de tension (3) qui comprennent respectivement un commutateur à semiconducteur (4) pour, cycliquement, relier à chaque fois une paire de balais du moteur à courant continu (2) à une tension d'alimentation (U_{Vers}) où l'en déconnecter,
- mesure de courants de circuit de roue libre dans des circuits de roue libre qui sont respectivement branchés en série avec un associé parmi les commutateurs à semiconducteur (4) et qui sont conçus pour le protéger contre une surtension lors de la mise hors circuit d'une charge à tension continue inductive du moteur à courant continu (2), les circuits de course libre étant mesurés avec un appareil de mesure du courant (8) commun à tous les circuits de roue libre, l'appareil de mesure du courant (8) possédant une résistance de mesure commune qui est présente dans tous les circuits de roue libre ;
- mesure du courant de circuit de roue libre ;
- détermination d'une valeur moyenne des courants de circuit de roue libre pendant une période pendant laquelle un ou plusieurs des commutateurs à semiconducteur (4) sont ouverts simultanément et le moteur à courant continu (2) étant ainsi déconnecté de la tension d'alimentation (U_{Vers}), la valeur moyenne du courant de roue libre étant divisée par le nombre des plusieurs commutateurs à semiconducteur (4) qui sont ouverts simultanément afin de dériver le courant de moteur (I_{Motor}) lorsque plusieurs commutateurs à semiconducteur (4) sont ouverts simultanément, et
- fourniture de la valeur moyenne des courants de circuit de roue libre comme une indication du courant de moteur (I_{Motor}).
